# EUROPÄISCHE PATENTSCHRIFT

(11) **EP 1 247 109 B1**
(45) Veröffentlichungstag und Bekanntmachung des Hinweises auf die Patenterteilung: **06.10.2004**
(21) Anmeldenummer: 00981333.8
(22) Anmeldetag: 02.12.2000
(51) Int. Cl.: G01R 15/12, H03F 3/72

(54) **ELEKTRISCHE SCHALTUNGSANORDNUNG ZUR UMFORMUNG EINER ELEKTRISCHEN EINGANGSGRÖSSE IN EINE ELEKTRISCHE AUSGANGSSPANNUNG**
ELECTRICAL CIRCUIT ARRANGEMENT FOR CONVERTING AN ELECTRICAL INPUT VARIABLE INTO AN OUTPUT ELECTRICAL VOLTAGE
CIRCUIT ELECTRIQUE POUR CONVERTIR UNE GRANDEUR D'ENTREE ELECTRIQUE EN UNE TENSION DE SORTIE ELECTRIQUE

(30) Priorität: 15.01.2000 DE 10001530
(43) Veröffentlichungstag der Anmeldung: 09.10.2002
(73) Patentinhaber: Bosch Rexroth AG, 97816 Lohr am Main (DE)
(72) Erfinder: KISON, Thomas, 97737 Gemünden (DE); MEISSELBACH, Alexander, 97794 Rieneck (DE)
(86) Internationale Anmeldenummer: PCT/EP2000/012138
(87) Internationale Veröffentlichungsnummer: WO 2001/051936

(56) Entgegenhaltungen:
- EP-A- 0 724 161
- US-A- 5 012 181
- GRAEME J: "PHASE COMPENSATION COUNTERACTS OP-AMP INPUT CAPACITANCE" EDN ELECTRICAL DESIGN NEWS,US,CAHNERS PUBLISHING CO. NEWTON, MASSACHUSETTS, Bd. 39, Nr. 1, 6. Januar 1994 (1994-01-06), Seiten 97-98,100,104, XP000474947 ISSN: 0012-7515

## Beschreibung

Die Erfindung betrifft eine elektrische Schaltungsanordnung zur Umformung einer elektrischen Eingangsgröße (Spannung oder Strom) in eine elektrische Ausgangsspannung gemäß dem Oberbegriff des Anspruchs 1.

In der Automatisierungstechnik erfolgt die Verknüpfung von Istwerten und Sollwerten sowie von Steuersignalen immer häufiger durch Mikroprozessoren. In vielen Fällen liegen die Istwerte und Sollwerte als Analogsignale, z. B. in Form von elektrischen Spannungen oder Strömen, vor. Da Mikroprozessoren nur digitale Signale verarbeiten können, müssen die Analogsignale digitalisiert werden, bevor sie von dem Mikroprozessor verarbeitet werden können. Die Digitalisierung erfolgt üblicherweise derart, daß ein Analog/Digital-Umwandler eine elektrische Spannung zwischen 0 V und +5 V in ein für die Verarbeitung durch einen Mikroprozessor geeignetes Digitalsignal umsetzt. Dabei entspricht eine Spannung von 0 V einem Signalwert von 0 % und eine Spannung von +5 V einem Signalwert von 100 %. Um auch Spannungen mit einem anderen Signalbereich, z. B. von 0 V bis +10 V oder von -10 V bis +10 V, oder Ströme mit einem Signalbereich von z. B. 0 mA bis 20 mA zu verarbeiten, müssen diese Signale zuvor in den für die Analog/Digital-Umwandlung vorgesehenen Signalbereich von 0 V bis +5 V umgesetzt werden. Hierzu werden je nach Anwendungsfall Schaltungsanordnungen, die eine Spannung in eine Spannung umsetzen, oder Schaltungsanordnungen, die einen Strom in eine Spannung umsetzen, verwendet. Für die unterschiedlichen elektrischen Eingangsgrößen sind somit jeweils unterschiedliche Schaltungsanordnungen auf Lager zu halten.

Aus der EP 0 724 161 ist eine Schaltungsanordnung zur Umformung einer elektrischen Eingangsgröße in eine Schaltungsanordnung gemäß dem Oberbegriff des Anspruchs 1 bekannt. Die bekannte Schaltungsanordnung dient zur Messung von jeweils drei Spannungen und von drei Strömen eines Drehstromsystems. Hierfür sind drei erste Rechenschaltungen mit je einem Operationsverstärker vorgesehen, die die jeweilige Eingangsspannung in entsprechende Ausgangsspannungen umformen. Die drei Ströme werden von je einem Stromwandler erfaßt. Im Ausgangskreis jedes Stromwandlers ist ein von seinem Ausgangsstrom durchflossener Widerstand angeordnet. Die an den drei Widerständen abfallenden Spannungen sind drei weiteren Rechenschaltungen zugeführt, die sie in den jeweils zu erfassenden Strömen entsprechende Ausgangsspannungen umformen. Ein elektronischer Umschalter schaltet jeweils eine Ausgangsspannung der sechs Rechenschaltungen auf den Eingang eines Analog/Digital-Wandlers, der die ihm zugeführte analoge Spannung in einen entsprechenden Zahlenwert umformt.

Aus der US 5,012,181 ist eine elektrische Einrichtung zur Kalibrierung elektrischer Meßgeräte bekannt, die sich zusätzlich von Zeit zu Zeit selbst kalibriert. Die Kalibriereinrichtung weist hierfür interne Referenzspannungen auf sowie verschiedene Rechenschaltungen, die einen Operationsverstärker enthalten. Anders als bei der EP 0 724 161 handelt es sich hier nicht um eine Einrichtung, die eine ihr von außen zugeführte elektrische Eingangsgröße, z. B. in Form einer Spannung oder eines Stroms, in eine der jeweiligen Eingangsgröße entsprechende elektrische Ausgangsspannung umformt.

Der Erfindung liegt die Aufgabe zugrunde, eine Schaltungsanordnung der eingangs genannten Art zu schaffen, die es erlaubt, elektrische Eingangsgrößen mit unterschiedlichem Signalbereich in eine eingeprägte Ausgangsspannung für einen gemeinsamen Signalbereich umzuformen.

Diese Aufgabe wird durch die im Anspruch 1 gekennzeichneten Merkmale gelöst. Die Erfindung führt zu einer Verringerung der Typenvielfalt und damit zu einer Senkung der Kosten für die Lagerhaltung. Darüber hinaus ist es auch möglich, später Istwertgeber zu verwenden, die einen anderen Signalbereich aufweisen, als die ursprünglich vorgesehenen Istwertgeber. In diesem Fall kann dieselbe Schaltungsanordnung zur Umformung der Eingangsgröße weiterverwendet werden.

Vorteilhafte Weiterbildungen der Erfindung sind in den Unteransprüchen gekennzeichnet. Sie betreffen Ausgestaltungen für die vorteilhafte schaltungstechnische Realisierung der erfindungsgemäßen Schaltungsanordnung.

Die Erfindung wird im folgenden mit ihren weiteren Einzelheiten anhand eines in den Zeichnungen dargestellten Ausführungsbeispiels näher erläutert. Es zeigen
- Figur 1: ein Prinzipschaltbild der erfindungsgemäßen Schaltungsanordnung,
- Figur 2: ein detailliertes Schaltbild der in der Figur 1 dargestellten Schaltungsanordnung,
- Figur 3: eine Ausgestaltung der ersten Rechenschaltung,
- Figur 4: eine Ausgestaltung der zweiten Rechenschaltung und
- Figur 5: das Blockschaltbild einer Einrichtung zur automatisierten Erfassung und Auswertung von Meßwerten mit einer erfindungsgemäßen Schaltungsanordnung.

In den Figuren sind gleiche Bauteile mit den gleichen Bezugszeichen versehen.

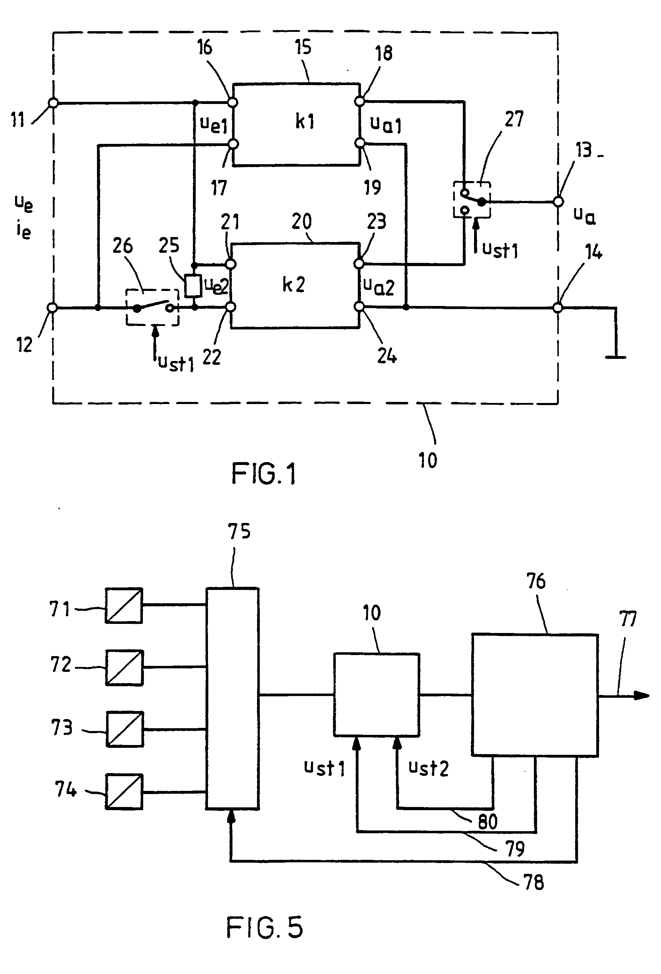

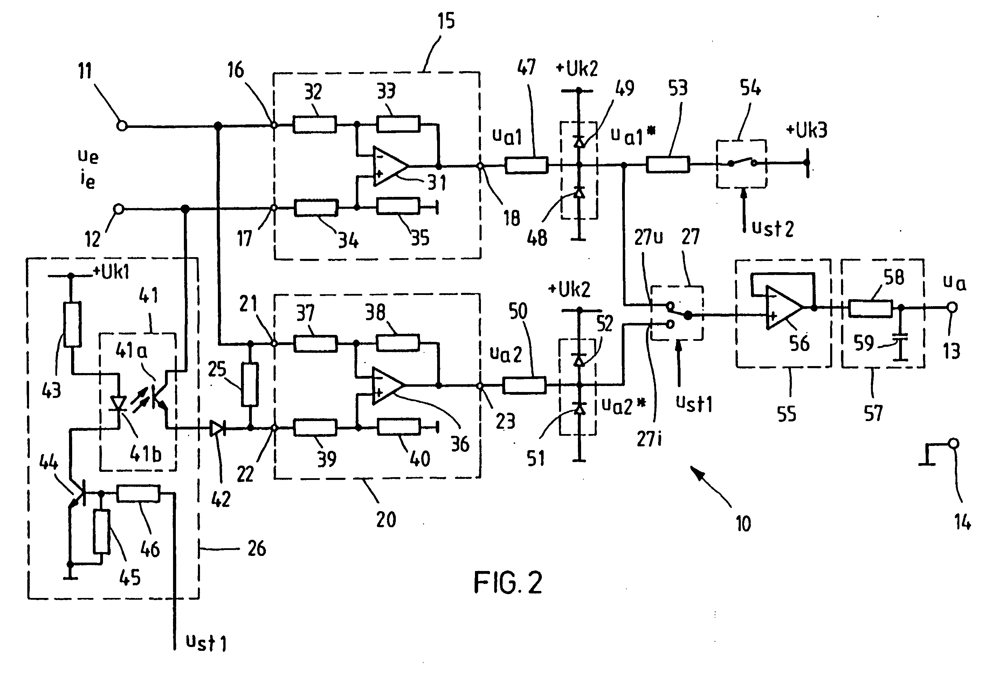

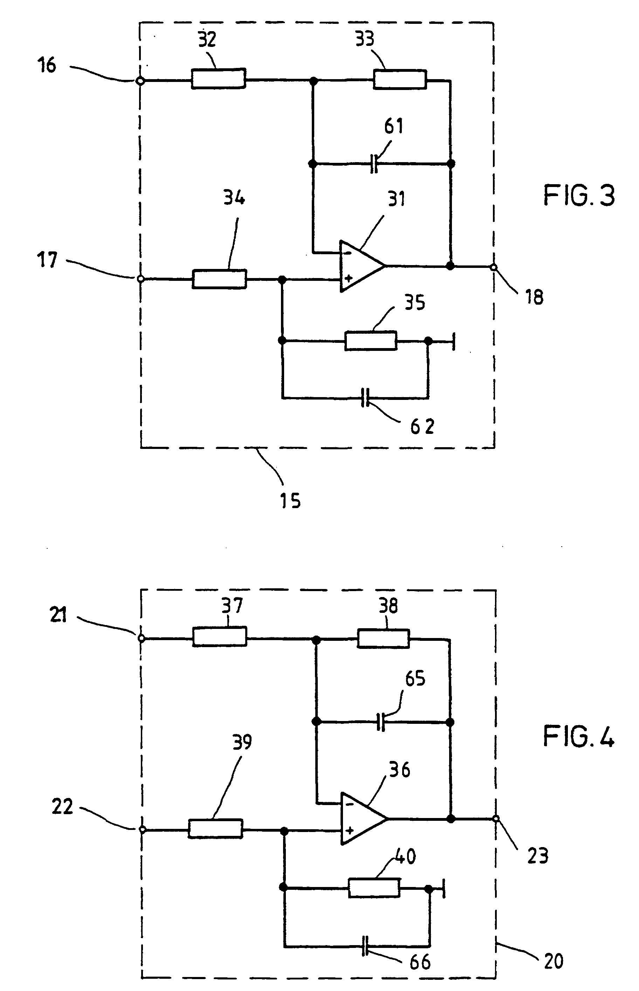

Die Figur 1 zeigt das Prinzipschaltbild einer elektrischen Schaltungsanordnung 10. Die Schaltungsanordnung 10 formt eine als Spannung ue oder als Strom ie vorliegende elektrische Eingangsgröße in eine eingeprägte Ausgangsspannung ua um, die proportional zu der jeweiligen Eingangsgröße ist. Die Eingangsspannung ue oder der Strom ie sind der Schaltungsanordnung 10 über Eingangsanschlüsse 11 und 12 zugeführt. Die Ausgangsspannung ua steht an Ausgangsanschlüssen 13 und 14 an. Der Ausgangsanschluß 14 ist mit Bezugspotential verbunden. Eine erste Rechenschaltung 15 mit Eingangsanschlüssen 16 und 17 sowie Ausgangsanschlüssen 18 und 19 formt eine ihr zugeführte Spannung ue1 in eine eingeprägte Spannung ua1 um. Der Verstärkungsfaktor der Rechenschaltung 15 ist mit k1 bezeichnet, damit gilt die Beziehung ua1 = k1 × ue1. Der Rechenschaltung 15 ist die an den Eingangsanschlüssen 11 und 12 anstehende Spannung ue zugeführt. Einzelheiten der Rechenschaltung 15 sind weiter unten anhand der Figuren 2 und 3 beschrieben. Eine zweite Rechenschaltung 20 mit Eingangsanschlüssen 21 und 22 sowie Ausgangsanschlüssen 23 und 24 formt eine ihr zugeführte Spannung ue2 in eine eingeprägte Spannung ua2 um. Der Verstärkungsfaktor der Rechenschaltung 20 ist mit k2 bezeichnet, damit gilt die Beziehung ua2 = k2 × ue2. Der Rechenschaltung 20 ist die an einem Widerstand 25 abfallende Spannung ue2 zugeführt. Der Widerstand 25 ist über einen Schalter 26 mit den Eingangsanschlüssen 11 und 12 verbunden. Ist der Schalter 26 geschlossen, fließt der Strom ie über den Widerstand 25, und die an dem Widerstand 25 abfallende Spannung ue2 ist proportional zu dem Strom ie. Einzelheiten der Rechenschaltung 20 sind weiter unten anhand der Figuren 2 und 4 beschrieben. Ein Umschalter 27 verbindet in Abhängigkeit von seiner Schaltstellung den Ausgangsanschluß 18 der Rechenschaltung 15 oder den Ausgangsanschluß 23 der Rechenschaltung 20 mit dem Ausgangsanschluß 13 der Schaltungsanordnung 10. Der Ausgangsanschluß 19 der Rechenschaltung 15 und der Ausgangsanschluß 24 der Rechenschaltung 20 und der Ausgangsanschluß 14 der Schaltungsanordnung 10 sind miteinander verbunden und liegen auf Bezugspotential. Der Schalter 26 und der Umschalter 27 sind als gesteuerte Schalter dargestellt, deren Schaltstellung durch eine Steuerspannung ust1 bestimmt sind. Es ist aber auch möglich, den Schalter 26 und/oder den Umschalter 27 in Form von Brücken, wie z. B. Lötbrücken oder Steckbrücken, zu realisieren. In diesem Fall ist keine Steuerspannung erforderlich.

Ist die elektrische Eingangsgröße, die in die Spannung ua umgeformt werden soll, eine Spannung ue, ist die Steuerspannung ust1 so gewählt, daß der Schalter 26 geöffnet ist und daß der Umschalter 27 den Ausgangsanschluß 18 mit dem Ausgangsanschluß 13 verbindet. In diesem Fall ist die Spannung ua gleich der Spannung ua1. Für den Zusammenhang zwischen der Ausgangsspannung ua und der Spannung ue gilt die Beziehung ua = k1 × ue.

Ist die elektrische Eingangsgröße, die in die Spannung ua umgeformt werden soll, ein Strom ie, ist die Steuerspannung ust1 so gewählt, daß der Schalter 26 geschlossen ist und daß der Umschalter 27 den Ausgangsanschluß 23 mit dem Ausgangsanschluß 13 verbindet. In diesem Fall ist die Spannung ua gleich der Spannung ua2. Für den Zusammenhang zwischen der Ausgangsspannung ua und dem Strom ie gilt die Beziehung ua = k2 × R25 × ie, wobei mit R25 der Wert des Widerstands 25 bezeichnet ist, der den Strom ie in die Spannung ue2 umformt.

Die Figur 2 zeigt ein detailliertes Schaltbild der in der Figur 1 dargestellten Schaltungsanordnung 10. Die Rechenschaltung 15 enthält einen Operationsverstärker 31, dessen Ausgang mit dem Ausgangsanschluß 18 verbunden ist. Zwischen dem Eingangsanschluß 16 und dem Ausgang des Operationsverstärkers 31 ist die Reihenschaltung von zwei Widerständen 32 und 33 angeordnet. Der Verbindungspunkt der Widerstände 32 und 33 ist mit dem invertierenden Eingang des Operationsverstärkers 31 verbunden. Zwischen dem Eingangsanschluß 17 und Bezugspotential ist die Reihenschaltung von zwei Widerständen 34 und 35 angeordnet. Der Verbindungspunkt der Widerstände 34 und 35 ist mit dem nichtinvertierenden Eingang des Operationsverstärkers 31 verbunden. Die Ausgangsspannung ua1 der Rechenschaltung 15 stellt sich so ein, daß die dem invertierenden Eingang des Operationsverstärkers 31 zugeführte Spannung gleich der an dem nichtinvertierenden Eingang des Operationsverstärkers 31 anstehenden Spannung ist. Der Verstärkungsfaktor k1 der Rechenschaltung 15 ist durch die Werte der Widerstände 32 bis 35 bestimmt. In dem vorliegenden Ausführungsbeispiel sind die Widerstände 33 und 35 gleich groß, die Widerstände 32 und 34 sind jeweils doppelt so groß wie die Widerstände 33 und 35. Aus dieser Beschaltung des Operationsverstärkers 31 ergibt sich der Verstärkungsfaktor k1 zu k1 = 0,5.

Die Rechenschaltung 20 weist grundsätzlich den gleichen Aufbau auf wie die Rechenschaltung 15. Die Rechenschaltung 20 enthält einen Operationsverstärker 36, dessen Ausgang mit dem Ausgangsanschluß 23 verbunden ist. Zwischen dem Eingangsanschluß 21 und dem Ausgang des Operationsverstärkers 36 ist die Reihenschaltung von zwei Widerständen 37 und 38 angeordnet. Der Verbindungspunkt der Widerstände 37 und 38 ist mit dem invertierenden Eingang des Operationsverstärkers 36 verbunden. Zwischen dem Eingangsanschluß 22 und Bezugspotential ist die Reihenschaltung von zwei Widerständen 39 und 40 angeordnet. Der Verbindungspunkt der Widerstände 39 und 40 ist mit dem nichtinvertierenden Eingang des Operationsverstärkers 36 verbunden. Die Ausgangsspannung ua2 der Rechenschaltung 20 stellt sich so ein, daß die dem invertierenden Eingang des Operationsverstärkers 36 zugeführte Spannung gleich der an dem nichtinvertieren Eingang des Operationsverstärkers 36 anstehenden Spannung ist. Der Verstärkungsfaktor k2 der Rechenschaltung 15 ist durch die Werte der Widerstände 37 bis 40 bestimmt. In dem vorliegenden Ausführungsbeispiel sind die Widerstände 38 und 40 gleich groß, sie sind jeweils 2,5 Mal so groß wie die Widerstände 37 und 39. Aus dieser Beschaltung des Operationsverstärkers 36 ergibt sich der Verstärkungsfaktor k2 zu k2 = 2,5.

Der in der Figur 2 dargestellte Schalter 26 weist einen nur schematisch dargestellten Optokoppler 41 mit einem Fototransistor 41a und einer Leuchtdiode 41b auf. Fließt über die Leuchtdiode 41b Strom, leuchtet sie und steuert den Fototransistor 41a in den leitenden Zustand. Im leitenden Zustand verbindet der Fototransistor 41a den Eingangsanschluß 12 der Schaltungsanordnung 10 über eine Diode 42 mit dem einen Anschluß des Widerstands 25. Die Diode 42 verhindert einen Stromfluß von dem Eingangsanschluß 11 der Schaltungsanordnung 10 zu dem Eingangsanschluß 12, wenn die Spannung am Eingangsanschluß 11 höher ist als die Spannung am Eingangsanschluß 12. Die Leuchtdiode 41b ist zwischen einem Widerstand 43 und einem Transistor 44 angeordnet. Zwei Widerstände 45 und 46 bilden einen Spannungsteiler, dessen Abgriff mit der Basis des Transistors 44 verbunden ist. Wird dem Widerstand 46 eine positive Steuerspannung ust1 zugeführt, leitet der Transistor 44, über die Leuchtdiode 41b fließt von einer konstanten Spannung Uk1 über den Widerstand 43 sowie den Transistor 44 Strom und die Leuchtdiode 41b schaltet den Fototransistor 41a in den leitenden Zustand. Der Widerstand 43 begrenzt den über die Leuchtdiode 41b fließenden Strom und über die Stromverstärkung des Optokopplers 41 auch den über den Fototransistor 41a fließenden Strom. Die Steuerspannung ust1 und die Spannung Uk1 sind in diesem Ausführungsbeispiel jeweils zu +5 V gewählt. Ist die Steuerspannung ust1 null, sperrt der Transistor 44 und der Fototransistor 41a sperrt ebenfalls.

Die Eingänge des Umschalters 27 sind im folgenden mit 27u und 27i bezeichnet. Der Eingang 27u ist über einen Widerstand 47 mit dem Ausgangsanschluß 18 der Rechenschaltung 15 verbunden. Zusätzlich ist der Eingang 27u über eine Diode 48 mit Bezugspotential und über eine weitere Diode 49 mit einer konstanten Spannung Uk2 verbunden. Die Dioden 48 und 49 begrenzen zusammen mit dem Widerstand 47 die an dem Eingang 27u anstehende, im folgenden mit ua1* bezeichnete Spannung. In entsprechender Weise ist die dem Eingang 27i des Umschalters 27 zugeführte, im folgenden mit ua2* bezeichnete Spannung durch einen Widerstand 50 und zwei Dioden 51 und 52 begrenzt. Die beiden Begrenzungsschaltungen verhindern, daß die Spannungen ua1* und ua2* größer als die Summe aus der Spannung Uk2 und der Durchlaßspannung der Dioden 49 bzw. 52 oder negativer als die Durchlaßspannung der Dioden 48 bzw. 51 werden.

Der Eingang 27u des Umschalters 27 ist zusätzlich über einen Widerstand 53 und einen Schalter 54 mit einer konstanten Spannung Uk3 verbunden. Die Schaltstellung des Schalters 54 ist durch eine zweite Steuerspannung ust2 bestimmt. Die Widerstände 47 und 53 bilden bei geschlossenem Schalter 54 einen Spannungsteiler, der von der einen Seite mit der Spannung ua1 und von der anderen Seite mit der Spannung Uk3 beaufschlagt ist.

Als Umschalter 27 und Schalter 54 dienen elektronische Analogschalter, die von einem digitalen Steuersignal geringer Leistung angesteuert werden. In dem von der Firma National Semiconductor unter der Bezeichnung CD4053BM/CD4053BC vertriebenen Bauelement sind drei elektronische Umschalter in einem gemeinsamen Gehäuse zusammengefaßt. Ein derartiges Bauelement benötigt wenig Platz auf der Schaltungsplatine. Die Umschalter weisen eine geringe Störanfälligkeit auf, da sie keine mechanischen Kontakte enthalten, die im Laufe der Zeit verschleißen können. Als digitale Steuersignale dienen die Steuerspannungen ust1 und ust2. In dem hier dargestellten Ausführungsbeispiel nehmen der Umschalter 27 und der Schalter 54 die gezeichneten Schaltstellungen bei ust1 = 0 V bzw. ust2 = 0 V ein. Bei ust1 = +5 V und ust2 = +5 V nehmen der Umschalter 27 bzw. der Schalter 54 die andere Schaltstellung ein.

Dem Umschalter 27 ist ein Impedanzwandler 55 nachgeschaltet. Der Impedanzwandler 55 besteht aus einem Operationsverstärker 56, dessen Ausgang mit seinem invertierenden Eingang verbunden ist und dessen nichtinvertierendem Eingang in Abhängigkeit von der Stellung des Umschalters 27 die Spannung ua1* oder ua2* zugeführt ist. Aufgrund des hohen Eingangswiderstands des Impedanzwandlers 55 erfolgt daher praktisch keine Belastung der Spannungen ua1* bzw. ua2*.

Dem Impedanzwandler 55 ist ein Filter 57 nachgeschaltet, das aus einem Widerstand 58 und einem Kondensator 59 gebildet ist. Das Filter 57 sorgt für eine Glättung der Ausgangsspannung ua der Schaltungsanordnung 10.

Für die Umwandlung einer unidirektionalen Eingangsspannung mit einem Wertebereich von z. B. 0 V bis +10 V in eine unidirektionale Ausgangsspannung mit einem Wertebereich von 0 V bis +5 V sind die Schalter 26 und 54 geöffnet, und der Umschalter 27 führt dem Impedanzwandler 55 die Spannung ua1* zu. Außerdem ist der Eingangsanschluß 11 der Schaltungsanordnung 10 mit Bezugspotential verbunden. Am Eingangsanschluß 12 steht somit eine positive Spannung an. Aufgrund der Beziehung ua1 = k1 × ue1 ergibt sich mit k1 = 0,5 für die Spannung ua1 ein Wertebereich von 0 V bis +5 V. Wegen des hohen Eingangswiderstands des Impedanzwandlers 55 fließt über den Widerstand 47 kein Strom, und die Spannung ua1* ist gleich der Spannung ua1. Wird die Spannung Uk2 gleich +5 V gewählt, erfolgt keine Begrenzung der Spannung ua1* für einen Wertebereich von 0 V bis +5 V. Die Ausgangsspannung ua der Schaltungsanordnung 10 ist die durch das Filter 57 geglättete Spannung ua1*. Der Eingangsanschluß 21 der Rechenschaltung 20 ist mit Bezugspotential verbunden. Da der Schalter 26 geöffnet ist, fließt über den Widerstand 25 kein Strom, d. h. der Eingangsanschluß 22 der Rechenschaltung liegt ebenfalls auf Bezugspotential. Aufgrund der Beziehung ua2 = k2 × ue2 ergibt sich mit k2 = 2,5 die Spannung ua2 zu null. Da über den Widerstand 50 kein Strom fließt, ist auch ua2* = 0 V. Dieser Wert liegt innerhalb der Ansprechgrenzen der aus dem Widerstand 50 und den Dioden 51 und 52 gebildeten Begrenzungsschaltung.

Für die Umwandlung einer bidirektionalen Eingangsspannung mit einem Wertebereich von z. B. -10 V bis +10 V in eine unidirektionale Ausgangsspannung mit einem Wertebereich von 0 V bis +5 V ist der Schalter 26 geöffnet, der Schalter 54 ist geschlossen und der Umschalter 27 führt dem Impedanzwandler 55 die Spannung ua1* zu. Außerdem ist der Eingangsanschluß 11 der Schaltungsanordnung 10 mit Bezugspotential verbunden. Am Eingangsanschluß 12 steht eine Spannung an, die sowohl positive als auch negative Werte annehmen kann. Aufgrund der Beziehung ua1 = k1 × ue1 ergibt sich mit k1 = 0,5 für die Spannung ua1 ein Wertebereich von -5 V bis +5 V. Bei geschlossenem Schalter 54 bilden die Widerstände 47 und 53 einen Spannungsteiler, der von der Rechenschaltung 15 her mit der Spannung ua1 beaufschlagt ist und dessen anderer Seite die Spannung Uk3 zugeführt ist. Mit Uk3 = +5 V und gleich groß gewählten Widerständen 47 und 53 ergibt sich für den Wertebereich der Spannung ua1 von -5 V bis +5V ein Wertebereich der Spannung ua1* von 0 V bis +5 V. Wegen des hohen Eingangswiderstands des Impedanzwandlers 55 erfolgt keine Belastung des aus den Widerständen 47 und 53 gebildeten Spannungsteilers durch die nachfolgenden Schaltungsteile. Wird die Spannung Uk2 - wie oben angegeben - gleich +5 V gewählt, erfolgt keine Begrenzung der Spannung ua1* für einen Wertebereich von 0 V bis +5 V. Die Ausgangsspannung ua der Schaltungsanordnung 10 ist die durch das Filter 57 geglättete Spannung ua1*. Wie in dem zuvor behandelten Fall der Umwandlung einer unidirektionalen Spannung ist der Eingangsanschluß 21 der Rechenschaltung 20 mit Bezugspotential verbunden. Da der Schalter 26 geöffnet ist, fließt über den Widerstand 25 kein Strom, d. h. der Eingangsanschluß 22 der Rechenschaltung liegt ebenfalls auf Bezugspotential. Aufgrund der Beziehung ua2 = k2 × ue2 ergibt sich mit k2 = 2,5 die Spannung ua2 zu null. Da über den Widerstand 50 kein Strom fließt, ist auch ua2* = 0 V. Dieser Wert liegt somit ebenfalls innerhalb der Ansprechgrenzen der aus dem Widerstand 50 und den Dioden 51 und 52 gebildeten Begrenzungsschaltung.

Für die Umwandlung eines unidirektionalen Eingangsstroms ie mit einem Wertebereich von z. B. 0 mA bis +20 mA in eine unidirektionale Ausgangsspannung mit einem Wertebereich von 0 V bis +5 V ist der Schalter 26 geschlossen, und der Umschalter 27 führt dem Impedanzwandler 55 die Spannung ua2* zu. Der Strom ie fließt von dem Eingangsanschluß 12 über den Fototransistor 41a, die Diode 42 und den Widerstand 25 zum Eingangsanschluß 11 der Schaltungsanordnung 10. Bei einem Widerstandswert von R25 = 100 Ω fällt an dem Widerstand 25 eine Spannung ue2 ab, deren Wertebereich zwischen 0 V und 2 V liegt. Aufgrund der Beziehung ua2 = k2 × ue2 ergibt sich mit k2 = 2,5 für die Spannung ua2 ein Wertebereich von 0 V bis +5 V. Wegen des hohen Eingangswiderstands des Impedanzwandlers 55 fließt über den Widerstand 50 kein Strom, und die Spannung ua2* ist gleich der Spannung ua2. Wird die Spannung Uk2 gleich +5 V gewählt, erfolgt keine Begrenzung der Spannung ua2* für den Wertebereich von 0 V bis +5 V. Die Ausgangsspannung ua der Schaltungsanordnung 10 ist die durch das Filter 57 geglättete Spannung ua2*. Den Eingangsanschlüssen 16 und 17 der Rechenschaltung 15 ist der um die Flußspannung der Diode 42 erhöhte Spannungsabfall an dem Widerstand 25 als Eingangsspannung ue1 zugeführt. Geht man von einer Siliziumdiode mit einer Flußspannung der Diode 42 von 0,7 V bei Stromfluß aus, ergibt sich für die Eingangsspannung ue1 der Rechenschaltung 15 ein Wertebereich von 0 V bis 2,7 V. Aufgrund der Beziehung ua1 = k1 × ue1 mit k1 = 0,5 nimmt die Spannung ua1 Werte im Bereich von 0 V bis 1,35 V an. Unabhängig von der Stellung des Schalters 54 liegt der Bereich der Spannung ua1* innerhalb der Ansprechgrenzen der aus dem Widerstand 47 und den Dioden 48 und 49 gebildeten Begrenzungsschaltung.

Ist der Schalter 26 versehentlich oder aufgrund einer Störung geschlossen, wenn eine positive Spannung an dem Eingangsanschluß 12 ansteht, wird der über den Fototransistor 41a, die Diode 42 und den Widerstand 25 fließende Strom, wie oben beschrieben, begrenzt, so daß im Störungsfall keine Beschädigungen von Bauelementen der Schaltungsanordnung zu befürchten sind. Zusätzlich erfolgt eine Begrenzung der Spannung ua2* durch den Widerstand 50 und die mit der Spannung Uk2 verbundene Diode 52. Die Spannung ua2* wird bei Verwendung einer Siliziumdiode auf ungefähr 5,7 V und im Fall einer Germaniumdiode auf ungefähr 5,3 V begrenzt. Dabei ist die Flußspannung einer Siliziumdiode mit 0,7 V und die Flußspannung einer Germaniumdiode mit 0,3 V berücksichtigt. Am Eingang 27i des Umschalters 27 liegt bei Verwendung von Germaniumdioden somit eine Spannung an, die Werte zwischen -0,3 V und 5,3 V annehmen kann. Die Verwendung von Germaniumdioden ist insbesondere dann vorteilhaft, wenn an die Anschlüsse 13 und 14 ein Mikroprozessor angeschlossen ist. Die Diode 42 verhindert einen Stromfluß über den Widerstand 25 und über den Fototransistor 41a, wenn an dem Eingangsanschluß 12 der Schaltungsanordnung 10 eine gegenüber dem Eingangsanschluß 11 negative Spannung ansteht. Da in diesem Fall über den Widerstand 25 kein Strom fließt, liegen die Eingangsanschlüsse 21 und 22 der Rechenschaltung 20 praktisch auf Bezugspotential und die Spannung ua2 ist null. Wird als Umschalter 27 ein elektronischer Analogschalter verwendet, ist es erforderlich, daß seine Eingänge nicht mit einer Spannung beaufschlagt werden, die negativer als seine negative Versorgungsspannung ist.

Die Figur 3 zeigt eine Erweiterung der in der Figur 2 dargestellten Rechenschaltung 15. Parallel zu dem Widerstand 33 ist ein Kondensator 61 angeordnet. Ein weiterer Kondensator 62 ist parallel zu dem Widerstand 35 angeordnet. Die zusätzlich vorgesehenen Kondensatoren 61 und.62 dienen zur Glättung der Ausgangsspannung ua1 der Rechenschaltung 15.

Die Figur 4 zeigt eine Erweiterung der in der Figur 2 dargestellten Rechenschaltung 20. Die Erweiterung der Rechenschaltung 20 ist entsprechend der Erweiterung der in der Figur 3 dargestellten Erweiterung der Rechenschaltung 15 ausgebildet. Parallel zu dem Widerstand 38 ist ein Kondensator 65 angeordnet. Ein weiterer Kondensator 66 ist parallel zu dem Widerstand 40 angeordnet. Die zusätzlich vorgesehenen Kondensatoren 65 und 66 dienen zur Glättung der Ausgangsspannung ua2 der Rechenschaltung 20.

Die Figur 5 zeigt als ein Anwendungsbeispiel für die erfindungsgemäße Schaltungsanordnung eine Einrichtung zur automatisierten Erfassung und Auswertung einer Reihe unterschiedlicher Meßwerte als Blockschaltbild. Die zu messenden Werte, wie z. B. Druck, Differenzdruck, Weg oder Temperatur, werden von Meßumformern 71 bis 74 in elektrische Signale umgeformt. In Abhängigkeit von dem Aufbau der Meßumformer ist das elektrische Ausgangssignal eine unidirektionale Spannung, eine bidirektionale Spannung oder ein unidirektionaler Strom. Ein elektronischer Umschalter 75 wählt jeweils eines dieser elektrischen Signale aus. Die erfindungsgemäße Schaltungsanordnung 10 formt das von dem elektronischen Umschalter 75 ausgewählte elektrische Signal in eine unidirektionale Spannung mit einem einheitlichen Wertebereich von - wie oben beschrieben - z. B. 0 V bis +5 V um. Diese Spannung ist einem Meßwertverarbeitungsgerät 76 zugeführt. Das Gerät 76 rechnet den Wertebereich von 0% bis 100% des ihm zugeführten Meßwerts in die entsprechende physikalische Einheit um. Der Meßwert kann angezeigt und/oder aufgezeichnet werden. Es kann auch über einen Informationskanal 77 weitergeleitet werden. Dabei kann der Informationskanal 77 analoger oder digitaler Natur sein. Die Abfrage der einzelnen Meßwerte kann programmgesteuert erfolgen. Hierzu führt das Gerät 76 dem Umschalter 75 über eine Signalleitung 78 ein Steuersignal zu, durch das die gewünschte Meßgröße ausgewählt wird. Gleichzeitig sind der Schaltungsanordnung 10 über weitere Signalleitungen 79 und 80 Steuersignale ust1 bzw. ust2 zugeführt, die die Schalter 26 und 54 sowie den Umschalter 27 der Schaltungsanordnung 10 entsprechend dem für die ausgewählte Meßgröße erforderlichen Übertragungsverhalten einstellen.

## Patentansprüche

1. Elektrische Schaltungsanordnung zur Umformung einer elektrischen Eingangsgröße (Spannung oder Strom) in eine elektrische Ausgangsspannung, wobei zwischen der Eingangsgröße und der Ausgangsspannung eine vorgegebene Zuordnung besteht,
- mit einer einen ersten Operationsverstärker (31) aufweisenden ersten Rechenschaltung (15), die eine ihr zugeführte Eingangsgröße in Form einer Spannung (ue1) in eine erste eingeprägte Spannung (ua1) umformt,
- mit einer einen zweiten Operationsverstärker (36) aufweisenden zweiten Rechenschaltung (20), die eine ihr zugeführte Eingangsgröße in Form einer an einem stromdurchflossenen Widerstand abfallenden Spannung (ue2) in eine zweite eingeprägte Spannung umformt (ua2),
- wobei für die Umformung einer als Spannung vorliegenden Eingangsgröße die Ausgangsspannung (ua1) der ersten Rechenschaltung (15) als Ausgangsspannung (ua) der Schaltungsanordnung dient und für die Umformung einer als Strom vorliegenden Eingangsgröße die Ausgangsspannung (ua2) der zweiten Rechenschaltung (20) als Ausgangsspannung (ua) der Schaltungsanordnung dient, und
- mit einem Umschalter (27) der jeweils den Ausgang einer der zwei Rechenschaltung (15, 20) mit dem Ausgang (13) der Schaltungsanordnung (10) verbindet,
**dadurch gekennzeichnet,**
- **daß** die elektrische Eingangsgröße (uₑ, iₑ) zwei Eingangsanschlüssen (11, 12) der elektrischen Schaltungsanordnung (10) zugeführt ist,
- **daß** je ein Eingangsanschluß (16, 17) der ersten Rechenschaltung (15) mit einem Eingangsanschluß (11, 12) der Schaltungsanordnung (10) verbunden ist,
- **daß** ein erster Anschluß des Widerstands (25) mit dem ersten Eingangsanschluß (11) der Schaltungsanordnung (10) verbunden ist,
- **daß** ein zweiter Anschluß des Widerstands (25) über einen ersten Schalter (26) mit dem anderen Eingangsanschluß (12) der Schaltungsanordnung (10) verbindbar ist,
- **daß** für die Umformung einer Spannung (uₑ) der erste Schalter (26) geöffnet ist und der Umschalter (27) die Ausgangsspannung (uₐ₁) der ersten Rechenschaltung (15) dem Ausgang (13) der Schaltungsanordnung (10) zuführt und
- **daß** für die Umformung eines Stroms (iₑ) der erste Schalter (26) geschlossen ist und der Umschalter (27) die Ausgangsspannung (uₐ₂) der zweiten Rechenschaltung (20 dem Ausgang(13) der Schaltungsanordnung (10) zuführt.

2. Schaltungsanordnung nach Anspruch 1, **dadurch gekennzeichnet,**
- **daß** der invertierende Eingang des ersten Operationsverstärkers (31).über einen zweiten Widerstand (33) mit seinem Ausgang und über einen dritten Widerstand (32) mit einem ersten Eingangsanschluß (16) der ersten Rechenschaltung (15) verbunden ist,
- **daß** der nichtinvertierende Eingang des ersten Operationsverstärkers (31) über einen vierten Widerstand (35) mit Bezugspotential und über einen fünften Widerstand (34) mit einem zweiten Eingangsanschluß (17) der ersten Rechenschaltung (15) verbunden ist,
- **daß** der invertierende Eingang des zweiten Operationsverstärkers (36) über einen sechsten Widerstand (38) mit seinem Ausgang und über einen siebten Widerstand (37) mit dem ersten Eingangsanschluß (21) der zweiten Rechenschaltung (20) verbunden ist,
- **daß** der nichtinvertierende Eingang des zweiten Operationsverstärkers (36) über einen achten Widerstand (40) mit Bezugspotential und über einen neunten Widerstand (39) mit dem zweiten Eingangsanschluß (22) der zweiten Rechenschaltung (20) verbunden ist.

3. Schaltungsanordnung nach Anspruch 2, **dadurch gekennzeichnet, daß** die mit den Eingängen der Operationsverstärker (31, 36) verbundenen Widerstände (32 bis 35; 37 bis 40) entsprechend der gewünschten Zuordnung zwischen Eingangsgröße (uₑ, iₑ) und Ausgangsspannung (uₐ) dimensioniert sind.

4. Schaltungsanordnung nach Anspruch 3, **dadurch gekennzeichnet, daß** parallel zu dem zweiten Widerstand (33), dem vierten Widerstand (35), dem sechsten Widerstand (38) und dem achten Widerstand (40) je ein Kondensator (61, 62, 65, 66) angeordnet ist.

5. Schaltungsanordnung nach einem der vorhergehenden Ansprüche, **dadurch gekennzeichnet, daß** zwischen dem Ausgang des Umschalters (27) und dem Ausgang (13) der Schaltungsanordnung (10) ein Impedanzwandler (55) angeordnet ist.

6. Schaltungsanordnung nach Anspruch 5, **dadurch gekennzeichnet, daß** dem Impedanzwandler (55) ein Filter (57) nachgeschaltet ist.

7. Schaltungsanordnung nach Anspruch 5 oder Anspruch 6, **dadurch gekennzeichnet,**
- **daß** der Ausgang (18) der ersten Rechenschaltung (15) über einen zehnten Widerstand (47) mit dem einen Eingang (27u) des Umschalters (27) verbunden ist,
- **daß** der Ausgang (23) der zweiten Rechenschaltung (20) über einen elften Widerstand (50) mit dem anderen Eingang (27i) des Umschalters (27) verbunden ist,
- **daß** der eine Eingang (27u) des Umschalters (27) über eine erste Diode (48) mit einer ersten konstanten Spannung (Bezugspotential) und über eine zweite Diode (49) mit einer zweiten konstanten Spannung (Uk2) verbunden ist und
- **daß** der andere Eingang (27i) des Umschalters (27) über eine dritte Diode (51) mit der ersten konstanten Spannung (Bezugspotential) und über eine vierte Diode (52) mit der zweiten konstanten Spannung (Uk2) verbunden ist.

8. Schaltungsanordnung nach Anspruch 7, **dadurch gekennzeichnet, daß** der eine Eingang (27u) des Umschalters (27) über einen zwölften Widerstand (53) und einen zweiten Schalter (54) mit einer dritten konstanten Spannung (Uk3) verbunden ist.

9. Schaltungsanordnung nach einem der vorhergehenden Ansprüche, **dadurch gekennzeichnet, daß** der erste Schalter (26) einen Optokoppler (41) aufweist.

10. Schaltungsanordnung nach Anspruch 9, **dadurch gekennzeichnet,** da**ß** zwischen dem Optokoppler (41) und dem ersten Widerstand (25) eine fünfte Diode (42) angeordnet ist.

11. Schaltungsanordnung nach einem der vorhergehenden Ansprüche, **dadurch gekennzeichnet, daß** der Umschalter (27) ein elektronischer Analogschalter ist.

12. Schaltungsanordnung nach einem der Ansprüche 8 bis 11, **dadurch gekennzeichnet, daß** der zweite Schalter (54) ein elektronischer Analogschalter ist.

13. Verwendung einer Schaltungsanordnung nach einem der vorhergehenden Ansprüche, bei der die für die Einstellung des Übertragungsverhaltens der Schaltungsanordnung vorgesehenen Schalter (26, 54) und Umschalter (27) durch elektrische Signale (uₛₜ₁, uₛₜ₂) steuerbar sind, zur Anpassung unterschiedlicher Eingangssignale (uₑ, iₑ) in einer Einrichtung zur automatisierten Erfassung und Auswertung von Meßwerten.

## Claims

1. Electrical circuit arrangement for converting an electrical input variable (voltage or current) into an electrical output voltage, there being a predefined relationship between the input variable and the output voltage,
- having a first arithmetic circuit (15), provided with a first operational amplifier (31), which converts an input variable fed to it in the form of a voltage (ue1) into a first impressed voltage (ua1),
- having a second arithmetic circuit (20), provided with a second operational amplifier (36), which converts an input variable fed to it in the form of a voltage (ue2) that drops across a current-carrying resistor into a second impressed voltage (ua2),
- wherein, for conversion of an input variable present as a voltage the output voltage (ua1) of the first arithmetic circuit (15) serves as the output voltage (ua) of the circuit arrangement and, for conversion of an input variable present as a current the output voltage (ua2) of the second arithmetic circuit (20) serves as the output voltage (ua) of the circuit arrangement, and
- having a changeover switch (27) which connects the output of one of the two arithmetic circuits (15, 20) in each case to the output (13) of the circuit arrangement (10),
**characterized by the fact**
- that the electrical input variable (ue, ie) is fed to two input terminals (11, 12) of the electrical circuit arrangement (10),
- that one input terminal (16, 17) in each case of the first arithmetic circuit (15) is connected to one input terminal (11, 12) of the circuit arrangement (10),
- that a first terminal of the resistor (25) is connected to the first input terminal (11) of the circuit arrangement (10),
- that a second terminal of the resistor (25) can be connected via a first switch (26) to the other input terminal (12) of the circuit arrangement (10),
- that, for the conversion of a voltage (ue), the first switch (26) is opened and the changeover switch (27) feeds the output voltage (ua1) of the first arithmetic circuit (15) to the output (13) of the circuit arrangement (10), and
- that for the conversion of a current (ie), the first switch (26) is closed and the changeover switch (27) feeds the output voltage (ua2) of the second arithmetic circuit (20) to the output (13) of the circuit arrangement (10).

2. Circuit arrangement according to claim 1, **characterized by the fact**
- that the inverting input of the first operational amplifier (31) is connected to its output via a second resistor (33), and to a first input terminal (16) of the first arithmetic circuit (15) via a third resistor (32),
- that the non-inverting input of the first operational amplifier (31) is connected to reference potential via a fourth resistor (35), and to a second input terminal (17) of the first arithmetic circuit (15) via a fifth resistor (34),
- that the inverting input of the second operational amplifier (36) is connected to its output via a sixth resistor (38) and to the first input terminal (21) of the second arithmetic circuit (20) via a seventh resistor (37),
- that the non-inverting input of the second operational amplifier (36) is connected to reference potential via an eighth resistor (40) and to the second input terminal (22) of the second arithmetic circuit (20) via a ninth resistor (39).

3. Circuit arrangement according to claim 2, **characterized by the fact that** the resistors (32 to 35; 37 to 40) which are connected to the inputs of the operational amplifiers (31, 36) are dimensioned according to the desired relationship between the input variable (ue, ie) and the output voltage (ua).

4. Circuit arrangement according to claim 3, **characterized by the fact that** a capacitor (61, 62, 65, 66) is arranged in each case in parallel with the second resistor (33), the fourth resistor (35), the sixth resistor (38) and the eighth resistor (40).

5. Circuit arrangement according to any of the preceding claims, **characterized by the fact that** an impedance converter (55) is arranged between the output of the changeover switch (27) and the output (13) of the circuit arrangement (10).

6. Circuit arrangement according to claim 5, **characterized by the fact that** a filter (57) is connected downstream of the impedance converter (55).

7. Circuit arrangement according to claim 5 or claim 6, **characterized by the fact**
- that the output (18) of the first arithmetic circuit (15) is connected to one input (27u) of the changeover switch (27) via a tenth resistor (47),
- that the output (23) of the second arithmetic circuit (20) is connected to the other input (27i) of the changeover switch (27) via an eleventh resistor (50),
- that the one input (27u) of the changeover switch (27) is connected to a first constant voltage (reference potential) via a first diode (48) and to a second constant voltage (Uk2) via a second diode (49), and
- that the other input (27i) of the changeover switch (27) is connected to the first constant voltage (reference potential) via a third diode (51) and to the second constant voltage (Uk2) via a fourth diode (52).

8. Circuit arrangement according to claim 7, **characterized by the fact that** the one input (27u) of the changeover switch (27) is connected to a third constant voltage (Uk3) via a twelfth resistor (53) and a second switch (54).

9. Circuit arrangement according to any of the preceding claims, **characterized by the fact that** the first switch (26) has an optocoupler (41).

10. Circuit arrangement according to claim 9, **characterized by the fact that** a fifth diode (42) is arranged between the optocoupler (41) and the first resistor (25).

11. Circuit arrangement according to any of the preceding claims, **characterized in that** the changeover switch (27) is an electronic analog switch.

12. Circuit arrangement according to any of claims 8 to 11, **characterized by the fact that** the second switch (54) is an electronic analog switch.

13. The use of a circuit arrangement according to any of the preceding claims, in which the switches (26, 54) and changeover switches (27) which are provided for setting the transmission behaviour of the circuit arrangement can be controlled by electrical signals (ust1, ust2) in order to adapt different input signals (ue, ie) in a device for automatically sensing and evaluating measured values.

## Revendications

1. Un dispositif de commutation électrique pour la transformation d'une valeur d'entrée électrique (tension ou courant) en une tension de sortie électrique, cependant qu'une relation donnée règne entre la valeur d'entrée et la tension de sortie,
- doté d'un premier branchement (15) de calcul, qui présente un premier amplificateur (31) opérationnel et qui transforme une valeur d'entrée lui étant ramenée sous forme de tension (ue1) en une première tension (ua1) indépendante de la charge,
- doté d'un second branchement (20) de calcul, qui présente un second amplificateur (36) opérationnel et qui transforme une valeur d'entrée lui étant ramenée sous forme d'une tension (ue2) qui chute au niveau d'une résistance parcourue par un courant en une seconde tension (ua2) indépendante de la charge,
- cependant que, pour la transformation d'une valeur d'entrée fournie sous forme de tension, la tension (ua1) de sortie du premier branchement (15) de calcul sert de tension (ua) de sortie du dispositif de commutation, et, pour la transformation d'une valeur d'entrée fournie sous forme de courant, la tension (ua2) de sortie du second branchement (20) de calcul sert de tension (ua) de sortie du dispositif de commutation, et
- doté d'un commutateur (27), qui relie la sortie de l'un des deux branchements (15, 20) de calcul, selon le cas, à la sortie (13) du dispositif (10) de commutation,
**caractérisé en ce**
- **que** la valeur (ue, ie) d'entrée électrique est ramenée vers deux connexions (11, 12) d'entrée du dispositif (10) de commutation électrique,
- **que** chacune des connexions (16, 17) d'entrée du premier branchement (15) de calcul est reliée à une connexion (11, 12) d'entrée du dispositif (10) de commutation,
- **qu'**une première connexion de la résistance (25) est reliée à la première connexion (11) d'entrée du dispositif (10) de commutation,
- **qu'**un premier interrupteur (26) permet de relier une seconde connexion de la résistance (25) à l'autre connexion (12) d'entrée du dispositif (10) de commutation,
- **que**, pour la transformation d'une tension (ue), le premier interrupteur (26) est ouvert et le commutateur (27) ramène la tension (ua1) de sortie du premier branchement (15) de calcul vers la sortie (13) du dispositif (10) dé commutation, et
- **que**, pour la transformation d'un courant (ie), le premier interrupteur (26) est fermé et le commutateur (27) ramène la tension (ua2) de sortie du second branchement (20) de calcul vers la sortie (13) du dispositif (10) de commutation,

2. Un dispositif de commutation selon la revendication n° 1, **caractérisé en ce**
- **que** l'entrée invertissante du premier amplificateur (31) opérationnel est reliée à sa sortie par une deuxième résistance (33) et à une première connexion (16) d'entrée du premier branchement (15) de calcul par une troisième résistance (32),
- **que** l'entrée non invertissante du premier amplificateur (31) opérationnel est reliée au potentiel de référence par une quatrième résistance (35) et à une deuxième connexion (17) d'entrée du premier branchement (15) de calcul par une cinquième résistance (34),
- **que** l'entrée invertissante du second amplificateur (36) opérationnel est reliée à sa sortie par une sixième résistance (38) et à la première connexion (21) d'entrée du second branchement (20) de calcul par une septième résistance (37),
- **que** l'entrée non invertissante du second amplificateur (36) opérationnel est reliée au potentiel de référence par une huitième résistance (40) et à la deuxième connexion (22) d'entrée du second branchement (20) de calcul par une neuvième résistance (39).

3. Un dispositif de commutation selon la revendication n° 2, **caractérisé en ce que** les résistances (32 à 35 ; 37 à 40) reliées aux entrées des amplificateurs (31, 36) opérationnels sont dimensionnées en fonction de la relation souhaitée entre la valeur (ue, ie) d'entrée et la tension (ua) de sortie.

4. Un dispositif de commutation selon la revendication n° 3, **caractérisé en ce qu'**un condensateur (61, 62, 65, 66) est branché en parallèle avec chacune des deuxième résistance (33), quatrième résistance (35), sixième résistance (38) et huitième résistance (40).

5. Un dispositif de commutation selon une des revendications précédentes, **caractérisé en ce qu'**un transformateur (55) d'impédance est disposé entre la sortie du commutateur (27) et la sortie (13) du dispositif (10) de commutation.

6. Un dispositif de commutation selon la revendication n° 5, **caractérisé en ce qu**'un filtre (57) est branché en aval du transformateur (55) d'impédance.

7. Un dispositif de commutation selon la revendication n° 5 ou la revendication n° 6, **caractérisé en ce**
- **que** la sortie (18) du premier branchement (15) de calcul est reliée à l'une des entrées (27u) du commutateur (27) par une dixième résistance (47),
- **que** la sortie (23) du second branchement (20) de calcul est reliée à l'autre entrée (27i) du commutateur (27) par une onzième résistance (50),
- **que** l'une des entrées (27u) du commutateur (27) est reliée à une tension constante (potentiel de référence) par une première diode (48) et à une deuxième tension (Uk2) constante par une deuxième diode (49) et
- **que** l'autre entrée (27i) du commutateur (27) est reliée à la première tension constante (potentiel de référence) par une troisième diode (51) et à la deuxième tension (Uk2) constante par une quatrième diode (52).

8. Un dispositif de commutation selon la revendication n° 7, **caractérisé en ce que** l'une des entrées (27u) du commutateur (27) est relié à une troisième tension (Uk3) constante par une douzième résistance (53) et un deuxième interrupteur (54).

9. Un dispositif de commutation selon une des revendications précédentes, **caractérisé en ce que** le premier interrupteur (26) présente un optocoupleur (41).

10. Un dispositif de commutation selon la revendication n° 9, **caractérisé en ce qu'**une cinquième diode (42) est disposée entre l'optocoupleur (41) et la première résistance (25).

11. Un dispositif de commutation selon une des revendications précédentes, **caractérisé en ce que** le commutateur (27) est un commutateur électronique analogique.

12. Un dispositif de commutation selon une des revendications n° 8 à n° 11, **caractérisé en ce que** le deuxième interrupteur (54) est un commutateur électronique analogique.

13. Une utilisation d'un dispositif de commutation selon une des revendications précédentes, pendant laquelle les interrupteurs (26, 54) et le commutateur (27), qui sont prévus pour le calibrage du comportement de transmission du dispositif de commutation, peuvent être commandés par des signaux électriques (ust1, ust2) pour l'adaptation de différents signaux (ue, ie) d'entrée dans un dispositif automatisé de saisie et d'évaluation de valeurs de mesure.
